# FASCICULE DE BREVET EUROPEEN

(11) **EP 3 989 300 B1**
(45) Date de publication et mention de la délivrance du brevet: **02.12.2026**
(21) Numéro de dépôt: 21204642.9
(22) Date de dépôt: 26.10.2021
(51) Int. Cl.: H10K 71/12, H10K 30/40, C30B 29/12, H10K 85/50, C30B 7/02, H10K 30/57

(54) **PROCÉDÉ DE FABRICATION D'UNE COUCHE DE PÉROVSKITE À MULTI-CATIONS**
VERFAHREN ZUR HERSTELLUNG EINER MULTIKATION-PEROWSKIT-SCHICHT
METHOD OF MANUFACTURING A MULTI-CATION PEROVSKITE LAYER

(30) Priorité: 26.10.2020 FR 2010958
(43) Date de publication de la demande: 27.04.2022
(73) Titulaire: Commissariat à l'Energie Atomique et aux Energies Alternatives, 75015 Paris (FR)
(72) Inventeur: FIEVEZ, Mathilde, 38054 Grenoble cedex 09 (FR); MANCEAU, Matthieu, 38054 Grenoble cedex 09 (FR); CROS, Stéphane, 38054 Grenoble cedex 09 (FR)
(74) Mandataire: Germain Maureau

(56) Documents cités:
- WO-A2-2020/209916
- US-A1- 2018 261 396
- ZUO CHUANTIAN ET AL: "One-step roll-to-roll air processed high efficiency perovskite solar cells", NANO ENERGY, vol. 46, 1 April 2018 (2018-04-01), pages 185 - 192, XP055817955, ISSN: 2211-2855, DOI: 10.1016/j.nanoen.2018.01.037
- ZUO CHUANTIAN ET AL: "Supporting Information One-Step Roll-to-Roll Air Processed High Efficiency Perovskite Solar Cells", 2 February 2018 (2018-02-02), XP055899291, Retrieved from the Internet <URL:https://www.sciencedirect.com/science/article/pii/S2211285518300454> [retrieved on 20220309]
- BABAYIGIT ASLIHAN ET AL: "Gas Quenching for Perovskite Thin Film Deposition", JOULE, vol. 2, no. 7, 1 July 2018 (2018-07-01), pages 1205 - 1209, XP055817957, ISSN: 2542-4351, DOI: 10.1016/j.joule.2018.06.009
- GAO LI-LI ET AL: "Boundary layer tuning induced fast and high performance perovskite film precipitation by facile one-step solution engineering", JOURNAL OF MATERIALS CHEMISTRY A, vol. 5, no. 34, 1 January 2017 (2017-01-01), GB, pages 18120 - 18127, XP055791671, ISSN: 2050-7488, DOI: 10.1039/C7TA05012G
- FAN YINGPING ET AL: "Review of Stability Enhancement for Formamidinium-Based Perovskites", SOLAR RRL, vol. 3, no. 9, 15 August 2019 (2019-08-15), pages 1900215, XP0055925828, ISSN: 2367-198X, Retrieved from the Internet <URL:https://onlinelibrary.wiley.com/doi/full-xml/10.1002/solr.201900215> DOI: 10.1002/solr.201900215

## Description

La présente invention se rapporte au domaine des couches en matériau de type pérovskite pour des applications dans le domaine microélectronique et optoélectronique. Plus particulièrement, la présente invention concerne un procédé de fabrication d'une couche de pérovskite hybride halogénée photo-active, et notamment une couche de pérovskite à multi-cations, pour une utilisation dans les dispositifs photovoltaïques, les LED's, les photo-détecteurs, les micro-batteries, ou autres dispositifs utilisant leurs propriétés semi-conductrices.

Les pérovskites hybrides halogénées sont des matériaux prometteurs et beaucoup de développements sont mis en œuvre afin d'améliorer leur qualité et leur stabilité, notamment pour la fabrication de cellules solaires. En effet, les cellules solaires hybrides organiques-inorganiques de pérovskite aux halogénures de plomb ont montré une augmentation remarquable de l'efficacité de conversion d'énergie sur une période de temps relativement courte (10 ans). Toutefois, les défis de cette technologie sont 1) la mise à l'échelle des procédés de déposition des différentes couches, tout particulièrement de la couche pérovskite, 2) la stabilité des dispositifs photovoltaïques sous conditions réelles et 3) la présence de Pb dans la couche absorbante de ces dispositifs. Cette invention s'intéresse au premier point. En effet, la majeure partie des procédés de fabrication qui ont été développés à ce jour pour déposer un matériau pérovskite ayant des propriétés physiques et optoélectroniques menant à des performances photovoltaïques élevées (>20%) sont réalisés à l'échelle du laboratoire, sur des petites surfaces. Ainsi, il subsiste un besoin de design et d'optimisation de procédés permettant la fabrication de couches pérovskites de qualité, à l'échelle industrielle, un coût raisonnable et sans dégradation de leurs propriétés.

Lorsqu'une méthode de dépôt à la tournette communément dénommée 'spin coating' est utilisée, les précurseurs de la couche de pérovskite visée sont mis en solution pour être étalés sur un substrat entrainé en rotation. La projection d'un anti-solvant sur le substrat en rotation permet d'amorcer la nucléation de la pérovskite et ainsi d'obtenir des films couvrants de grande qualité optoélectronique. Toutefois, lorsque cette méthode de dépôt est utilisée sur une grande surface, un film humide non-homogène est produit, par inhomogénéité de l'effet centrifuge. D'autres méthodes de dépôt existent tel que le blade coating, le slot die coating, ou l'inkjet printing, etc... Bien que ces méthodes soient plus adaptées au dépôt d'une solution précurseur industrielle, un problème majeur réside dans la difficulté d'obtenir la cristallisation du film de pérovskite étalé sur le substrat, quelle que soit la méthode de formation du film. L'utilisation de la méthode de l'anti-solvant, reposant sur l'effet centrifuge est peu adaptée aux substrats de grande dimension. De plus, cette méthode utilise classiquement un solvant toxique ou dangereux (chlorobenzène ou toluène) avec des opérateurs travaillant en boîtes à gants, environnement non adapté pour une utilisation à l'échelle industrielle.

De plus, l'obtention de cristaux de pérovskite de qualité est toujours associée à un recuit thermique long et/ou à forte température. En plus d'être coûteux, ce recuit rallonge le temps de cycle de fabrication.

WO 2020/209916 A2 décrit une solution d'encre, comprenant : i. une composition ayant la formule ABX₃; ii. un composé ayant la formule NH₂-R₁-NH₂; et iii. un solvant. L'invention concerne en outre des procédés de production de films de pérovskite polycristallin utilisant les solutions d'encre selon l'invention et l'utilisation des films dans des applications photovoltaïques et photoactives.

La publication de Zuo Chuantian et al. intitulée « One-step roll-to-roll air processed high effciency perovskite solar cells », Nano Energy, vol. 46, 1 avril 2018, pages 185-192 décrit la fabrication de cellules solaires comprenant une couche de pérovskite mettant notamment en œuvre la technique du « slot die coating ». Plus précisément, au 2^{ème} § du chapitre 4.3 de la page 190, il est décrit que la fabrication de cellules solaires comprenant une couche de pérovskite par « slot die coating » a été mise en œuvre de la manière suivante :
- 0.65 mol/L d'une solution de CH₃NH₃PbI₃ additionnée de 10 mg/mL de NH4Cl a été déposée par « slot die coating » sur un substrat de PEDOT :PSS modifié à une vitesse de dépôt de 8 mm/s. La température de dépôt était fixée à 60°C ;
- un flux gazeux de N2 avec un débit d'écoulement de 20 L/minute a été utilisé pour sécher le film lors du revêtement.

Il est en outre précisé au 1^{er} § du chapitre 4.3 que le flux gazeux de diazote a été appliqué à l'aide d'un tube en plastique dont le diamètre interne était de 4 mm. Ainsi, la vitesse du flux gazeux de diazote était de 26,5 m/s.

La publication de Gao Li-li et al., intitulée « Boundary layer tuning induced fast and high performance perovskite film precipitation by facile one-step solution engineering », Journal of Materials Chemistry A, vol. 5 n°34, 1 janvier 2017, pages 18120-18127, décrit une précipitation rapide et performante d'un film de pérovskite mettant en œuvre une vélocité de l'air de 45,87 m/s à 20°C de manière à accélérer l'évaporation du solvant en réduisant l'épaisseur de la couche limite.

Un des buts de la présente invention vise à pallier au moins l'un de ces inconvénients. A cet effet, l'invention propose un procédé de fabrication d'une couche de pérovskite à multi-cations, en vue de former une couche photo-active, le procédé comprenant les étapes de :
- a) fourniture d'un substrat présentant une face de dépôt,
- b) dépôt d'une solution précurseur comprenant au moins un solvant et des précurseurs de la pérovskite de sorte à former un film humide sur la face de dépôt, les précurseurs comprenant au moins du CsX, FAY, PbZ₂, avec X, Y et Z = I, Br, et les quantités étant déterminées de sorte que le rapport molaire du césium par rapport au plomb est compris entre environ 4% et 22 %, et de préférence entre 13% et 20%, et que la couche de pérovskite présente une formule brute du type CsₓFA₍₁₋ₓ₎Pb(I_{y}Br_{(1-y)})₃ avec x compris entre 0.04 et 0.22 et y compris entre 0 et 1, et
- c) balayage d'une surface exposée du film humide par un flux d'air sec ou de gaz inerte présentant une vitesse supérieure ou égale à 120 m/s de sorte à cristalliser la couche de pérovskite à multi-cations,
- le procédé comprenant en outre l'application d'un traitement thermique sur le substrat de sorte que la face de dépôt présente une température allant d'environ 25°C à 80°C au moins pendant l'étape b)
ledit procédé se caractérise en ce que la vitesse du flux d'air sec ou de gaz inerte est comprise entre 120 m/s et 250 m/s.

Contre toute attente, cette combinaison de paramètres relatifs au traitement thermique appliqué au substrat, la composition de la solution précurseur utilisée, la méthode de dépôt et la méthode de cristallisation, notamment la vitesse du flux gazeux associée à la composition de la solution précurseur, permet d'obtenir une couche de pérovskite de très bonne qualité cristalline, sur l'ensemble de sa surface, comme on pourra le voir ci-après. De plus, la fabrication de cellules photovoltaïques utilisant la couche de pérovskite photo-active ainsi fabriquée donne des résultats d'efficacité similaires à ceux obtenu avec une couche déposée par 'spin coating' sur une petite surface et ayant subi un recuit thermique après conversion du film humide.

Par ailleurs, la technique de dépôt utilisée dans le procédé de l'invention peut être avantageusement utilisée à échelle industrielle, le dépôt sur une surface de 5 x 5 cm² a d'ailleurs donné de bons résultats. Les poudres des matériaux précurseurs utilisés ne sont pas instables et sont donc compatibles avec une solution industrielle. La cristallisation selon l'invention ne nécessite pas l'application de recuit thermique important postérieur à l'étape c) d'application de flux gazeux, ce qui réduit les coûts de fabrication et d'éventuels endommagements dans la structure cristalline.

En outre, le spectre d'absorption des pérovskites hybrides formées par le procédé de la présente invention, présentant une formule brute du type CsₓFA₍₁₋ₓ₎Pb(I_{y}Br_{(1-y)})₃ comprenant du plomb, des halogénures et deux cations est très intéressant et peut être modifié notamment en ajustant le taux des halogénures dans la composition.

Il est également entendu par l'expression 'air sec', un air comprimé (8 bar) dont le point de rosée est inférieur à -20°C, et de préférence le point de rosée est inférieur à -40°C.

Selon une disposition, la surface exposée du film humide correspond à la totalité de la face exposée du film humide de sorte que la totalité du film humide est balayée par le flux d'air sec ou de gaz inerte.

Dans le présent document, le terme FA est bien connu par l'homme de l'art dans le domaine des pérovskites et désigne le Formamidinium HC(NH₂)₂⁺.

Selon une possibilité, l'application d'un traitement thermique sur le substrat est réalisée de sorte que la face de dépôt présente une température allant entre 30°C et 70°C, et de préférence entre environ 40°C et 60°C. Il est en effet intéressant de limiter le traitement thermique appliqué au substrat pour des raisons économiques. Si le solvant du film humide s'évapore moins facilement à 40°C qu'à 80°C, il est possible de compenser en augmentant la vitesse du flux gazeux.

Selon une disposition, ledit traitement thermique est apliqué sur le substrat de sorte que la face de dépôt présente une température allant d'environ 25°C à 80°C pendant l'étape b) et l'étape c).

Selon une variante de réalisation, les précurseurs de la couche de pérovskite sont choisis parmi une combinaison de CsX, FAY etPbZ₂, avec X, Y et Z = I , Br. Autrement dit, dans cette variante la solution de précurseurs est dépourvue d'autres précurseurs que ceux mentionnés dans la liste ci dessus.

Selon une autre possibilité, la solution précurseur consiste en les précurseurs choisis parmi du CsX, FAY, PbZ₂, et toute leur combinaison, avec X, Y et Z choisi parmi I et Br et au moins un solvant. Autrement dit, la solution précurseur est dépourvue de tout élément autre qu'au moins un solvant, les précurseur CsX, FAX, PbX₂, et toute leur combinaison, avec X choisi parmi I et Br. La composition de la solution précurseur est ainsi dépourvue de tout additif, ainsi que de cation MA⁺ (méthylammonium) dont la présence peut altérer la stabilité de la couche obtenue.

Selon une autre variante, la solution précurseur de l'étape b) comprend en outre un matériau chloré comme le PbCl₂. Bien entendu, les quantités de l'au moins un solvant, des précurseurs et du matériau chloré, tel que le PbCl₂, étant déterminées de sorte que la couche de pérovskite présente une formule brute du type CsₓFA₍₁₋ₓ₎Pb(I_{y}Br_{(1-y)})₃ avec x compris entre 0,04 et 0.22 et y compris entre 0 et 1. Selon la formule brute de la couche de pérovskite visée, il a été en effet observé que la présence de l'ion chlorure dans la solution précurseur facilite l'obtention de la cristallisation de la couche. Toutefois, comme rapporté à plusieurs reprises et notamment par Qi Jiang et al. 'Surface passivation of perovskite film for efficient solar cells' dans Nature Photonics Volume 13, pages 460-466 (2019),et Jason J. Yoo et al. 'An interface stabilized pérovskite solar cell with high stabilized efficiency and low voltage loss dans Energy & Environmental Science Issue 7, 2019', il a été observé que le chlore n'était pas ou très peu intégré dans la couche de pérovskite formée à l'issu du procédé. D'après la littérature, il est indiqué qu'il est parfois retrouvé sous forme de résidus de PbCl₂ et des analyses effectuées à l'aide d'un synchrotron indiquent une présence de chlore à l'état de trace dans la pérovskite selon le procédé utilisé. Certaines hypothèses émises font part d'une éventuelle évaporation lors de traitement thermique de cristallisation pour expliquer son absence dans la pérovskite obtenue.

Selon une autre disposition, la solution précurseur utilisée dans le procédé est dépourvue de tout matériau chloré.

Dans le présent document on entend par 'couche de pérovskite' une couche polycristalline de pérovskite, par opposition notamment à une couche amorphe.

Selon une possibilité, l'au moins un solvant est choisi parmi le DMF et/ou le DMSO. Le choix de la composition de l'au moins un solvant est un élément important pour faciliter la préparation de la solution précurseur par dissolution des éléments précurseurs du matériau pérovskite et la cristallisation qui implique l'évaporation dudit au moins un solvant.

Selon une disposition, la solution précurseur comprend une concentration molaire de plomb comprise entre 0.5 M et 1.5 M et de préférence entre 1 M et 1.3 M.

De préférence, le seul budget thermique appliqué pendant le procédé de fabrication est fourni par le traitement thermique appliqué au substrat de sorte que la face de dépôt présente une température allant d'environ 25°C à 80°C pendant les étapes b) et c).En pratique, ledit traitement thermique est appliqué avant l'étape b) de dépôt de sorte que la face de dépôt présente la température souhaitée au moment de démarrer le dépôt et il est stoppé à la fin de l'étape c).

Selon une autre possibilité, l'étape c) d'application du flux de gaz inerte ou d'air sec est suivie, après obtention de la couche de pérovskite cristalline, d'une étape d) d'application d'un recuit thermique réalisé à une température comprise entre 70°C et 100°C pendant une durée inférieure ou égale à 5 min. Cette option peut être utile pour certaines formules brutes de pérovskite visées, selon les valeurs de x et y de la formule brute CsₓFA₍₁₋ₓ₎Pb(I_{y}Br_{(1-y)})₃, on peut souhaiter faire disparaitre toute trace infime de matériaux précurseurs ou de solvant résiduel qui ne serait pas éliminée à l'étape c). Cette éventuelle étape d) diffère du recuit thermique connu dans l'art antérieur notamment par sa durée.

De préférence, l'étape c) de balayage par un flux de gaz inerte ou d'air sec est réalisée par un déplacement relatif du substrat comprenant le film humide et d'une buse de projection, telle qu'une buse de projection d'un couteau à gaz, la buse de projection étant disposée de sorte que la longueur L de la trajectoire du flux du gaz inerte ou d'air sec entre la sortie de la buse de projection et la surface exposée du film humide est comprise entre environ 3.1 millimètres et 6 millimètres, et de préférence entre environ 3.1 millimètres et 4 millimètres.

Plus précisément, la sortie de la buse de projection est délimitée par une lèvre basse et une lèvre haute espacées l'une de l'autre de sorte à former un espace de projection du flux de gaz inerte ou d'air sec sous une forme globale de lame, la lèvre basse définissant un point bas B et la lèvre haute définissant un point haut H. Il est entendu dans le présent document que la longueur L de la trajectoire du flux du gaz inerte ou d'air sec entre la sortie de la buse de projection et la surface exposée du film humide est mesurée entre le point haut H et la surface exposée du film humide. Comme on le verra ci-après et en référence aux figures annexées 4 et 5, ladite longueur L dépend de l'angle α formé entre le film humide et la direction du flux de gaz inerte ou d'air sec.

Il est entendu que la vitesse du flux du gaz inerte ou de l'air sec indiquée dans le présent document est mesurée et/ ou calculée à la sortie d'une buse de projection d'un dispositif de projection dudit flux. La vitesse du flux est fonction du débit de gaz et de la surface de l'ouverture à la sortie de la buse de projection.

Dans le présent document, l'expression 'couteau à gaz' ou 'couteau d'air' correspond à l'expression bien connue de l'homme du métier sous l'appelation anglosaxonne respectivement « gas knife » et « air knife ».

De préférence, la vitesse de déplacement relatif entre le film humide et la buse de projection lors de l'étape c) est comprise entre 1 et 50 mm/s et de préférence entre 5 et 30 mm/s.

Selon une disposition, l'angle α formé entre le flux de gaz inerte ou d'air sec et le film humide est compris entre 90° et 45°.

Avantageusement, l'étape b) de dépôt de la solution précurseur est effectuée par enduction via une filière plate ou via un couchage à lame, de sorte à obtenir un film humide d'une épaisseur constante et d'une concentration homogène. Ces techniques de dépôt sont en effet utilisées sur de grandes surfaces de dépôt nécessaires dans une solution industrielle.

Dans le présent document, l'expression 'enduction via une filière plate' correspond à la technique bien connue de l'homme du métier sous la dénomniation anglosaxone 'slot die coating'. De la même façon, l'enduction par couchage à lame correspond à la technique bien connue de l'homme du métier sous la dénomniation anglosaxone 'blade coating' parfois également nommée enduction par 'lame à enduction'.

Selon une disposition, l'étape b) de dépôt consiste à déposer la solution précurseur par une tête de dépôt du dispositif de slot die coating sur la face de dépôt, avec un débit compris entre 80 et 125 microlitre/min pour une concentration molaire du plomb dans la odlsution précurseur comprise entre 1 M et 1.3M.

Selon une possibilité, l'étape b) de dépôt de la solution précurseur est réalisée de sorte à obtenir une épaisseur de film humide constante, comprise entre 2 et 16 micromètres préférentiellement entre 2,5 et 8 micromètres et de préférence encore entre 3 et 5 micromètres.

Ces plages d'épaisseurs du film humide garantissent qu'il est possible à l'étape c) d'obtenir la cristallisation de la couche de pérovskite avec une bonne qualité et un bon rendement. Ces épaisseurs dépendent bien entendu de la concentration de la solution précurseur pour obtenir une couche de pérovskite cristalline d'une épaisseur comprise dans une plage d'environ 350- 600 nm.

Afin de diminuer le budget thermique appliqué aux étapes b) et c) tout en maitenant une bonne cristallisaiton de la couche de pérovksite, il est possible de limiter la vitesse de balayage du film par la buse de projection.

Un autre levier consiste à modifier la concentration dans la solution précurseur, au sein des plages ci-dessus indiquées.

Il est également possible de se placer dans une partie basse de la plage de la longueur L de la trajectoire du flux gazeux . En pratique, la buse de projection est rapprochée de la surface exposée du film humide, avec une distance verticale D entre 100 à 400 micromètres par exemple.

Une autre option consiste à choisir une vitesse du flux de gaz inerte ou d'air sec pamir les plus rapides des possibilités offertes par la buse de projection, par exemple de 135 m/s à 250 m/s.

Selon d'autres caractéristiques, le procédé de fabrication de l'invention comporte une ou plusieurs des caractéristiques optionnelles suivantes considérées seules ou en combinaison :
- La vitesse relative entre la face de dépôt et la tête de dépôt (cas du slot die coating) de la solution précurseur ou de la lame d'étalement (cas du blade coating) est comprise entre environ 1 et 100 mm/s et de préférence entre 20 et 45 mm/s et encore de préférence entre environ 25 et 30 mm/s.
- L'application du flux de gaz inerte ou d'air sec selon l'étape c) est réalisé sur la surface exposée du film humide avant la fin du dépôt de la solution précurseur selon l'étape b).
- L'application du flux de gaz inerte ou d'air sec selon l'étape c) est réalisé sur la surface exposée du film humide après la fin du dépôt de la solution précurseur selon l'étape b).
- La vitesse relative entre la tête de dépôt ou la lame d'étalement de la solution précurseur et la face de dépôt est similaire à la vitesse relative entre le film humide et la buse de projection du flux de gaz inerte ou d'air sec.
- La vitesse relative entre la tête de dépôt ou la lame d'étalement et la face de dépôt est supérieure à la vitesse relative entre le film humide et la buse de projection du flux de gaz inerte ou d'air sec.
- La vitesse relative entre la tête de dépôt ou la lame d'étalement et la face de dépôt est inférieure à la vitesse relative entre le film humide et la buse de projection du flux de gaz inerte ou d'air sec.
- Le déplacement entre la face de dépôt et la tête de dépôt (ou la lame d'étalement) et le déplacement entre la surface exposée du film humide et la buse de projection consiste en mouvement de translation, dans la direction d'extension longitudinale de la face de dépôt.
- Le flux d'air sec ou de gaz inerte est distribué à partir d'une source de gaz comprimé. Il est projeté sur la surface exposée du film humide à une température d'environ 15°C à 25°C sans étape de réchauffage intermédiaire.
- La distance verticale D entre la surface exposée du film humide et le point B de la sortie de la buse de projection est comprise entre 100 micromètres et 1 mm et de préférence entre 200 et 400 micromètres.
- La buse de projection est dépourvue de méplat de sorte que M = 0 et le point bas B et le point haut H sont à la même distance verticale D de la surface exposée du film humide.
- Le traitement thermique du substrat est réalisé en plaçant le substrat sur une plateforme chauffante dédiée, de sorte que le support est chauffé au travers une face opposée à la face de dépôt du film humide.
- Le traitement thermique est stoppé à la fin de l'étape b).
- La tête de dépôt de la solution précurseur est disposée à une distance, mesurée à l'aplomb de la face de dépôt, comprise entre 25 et 500 micromètres et de préférence entre environ 80 et 125 micromètres, et encore de préférence environ 100 micromètres.
- Les étapes a) à c) et le traitement thermique sont réalisées dans une enceinte de salle blanche présentant une température comprise entre 20 et 35°C.
- Les étapes a) à c) et le traitement thermique sont réalisées dans une enceinte de salle blanche présentant un taux d'humidité relative compris entre 8 et 38%.
- La salle blanche présente une température d'environ 21°C et un taux d'humidité relative d'environ 35%.
- La couche de pérovskite obtenue à l'étape c) présente une épaisseur d'environ 500 nanomètres.
- Le procédé de fabrication est dépourvu d'un traitement anti-solvant de conversion du film humide en film cristallin.
- Le substrat utilisé pour le dépôt est un substrat de type wafer de quelques centaines de micromètres, par exemple en silicium ou en verre, ou bien un substrat mince et souple se présentant sous une forme enroulée. Dans ce dernier cas, le substrat est entrainé par un mouvement de translation conduisant à son déroulement et son déplacement sous le dispositif de slot die coating ou de blade coating immobiles, et sous la buse de projection de flux de gaz inerte ou d'air sec également immobile.

L'invention sera davantage comprise à la lecture de la description non limitative qui va suivre, faite en référence aux figures ci-annexées.
La figure 1 est une vue schématique illustrant les étape a) à b) d'un mode de réalisation du procédé de l'invention.
La figure 2 est une vue schématique illustrant les étape b) et c) du procédé de l'invention.
La figure 3 est une vue schématique illustrant l'étape c) du procédé de l'invention.
La figure 4 est une vue schématique de la sortie d'une buse de projection du flux de gaz selon l'étape c) du procédé de l'invention.
La figure 5 est une vue schématique d'une buse de projection inclinée selon l'étape c) du procédé de l'invention.
La figure 6 est un graphique illustrant la rugosité de la couche de pérosvkiste obtenue selon un mode de réalisation du procédé de l'invention en fonction du rapport en Cs/Pb.
La figure 7 est une vue schématique d'une architecture de la structure pour cellule solaire de type NIP formée à partir d'une couche de pérovskite 100 fabriquée selon un mode de réalisation du procédé de l'invention.

Dans les exemples suivants, le PbI₂ utilisé est pur à 99,99% et provient de chez TCI Chemicals (Japon), le PbBr₂, FAI, Csl, DMF et DMSO proviennent de chez Sigma Aldrich.

Le couteau à gaz utilisé est l'équipement Silent X-Stream Air Blade, disponible chez fournisseur AirFlow.

Le slot die coating est réalisé à l'aide de l'équipement Automatic-Research TFC 300.

Le blade coating est réalisé à l'aide d'une lame de dépôt Zehntner ZUA 2000.

Dans ces exemples décrits ci-dessous, le substrat 1 et la face de dépôt 2 sont immobiles mais selon une disposition particulière, le substrat 1 et donc la face de dépôt 2 se déplace tandis que le dispositif de dépôt du film humide (slot die coating ou blade coating) et le dispositif de projection du flux gazeux (couteau à gaz) sont immobiles (cas du substrat souple se présentant sous forme enroulée).

### Premier exemple de réalisation du procédé de fabrication d'une couche de pérovskite 100 cristalline selon l'invention par slot die coating :

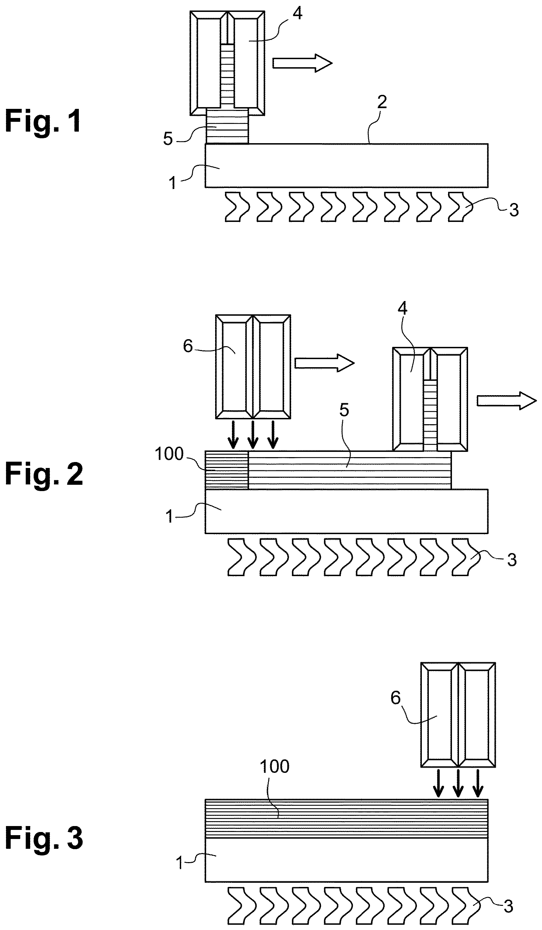

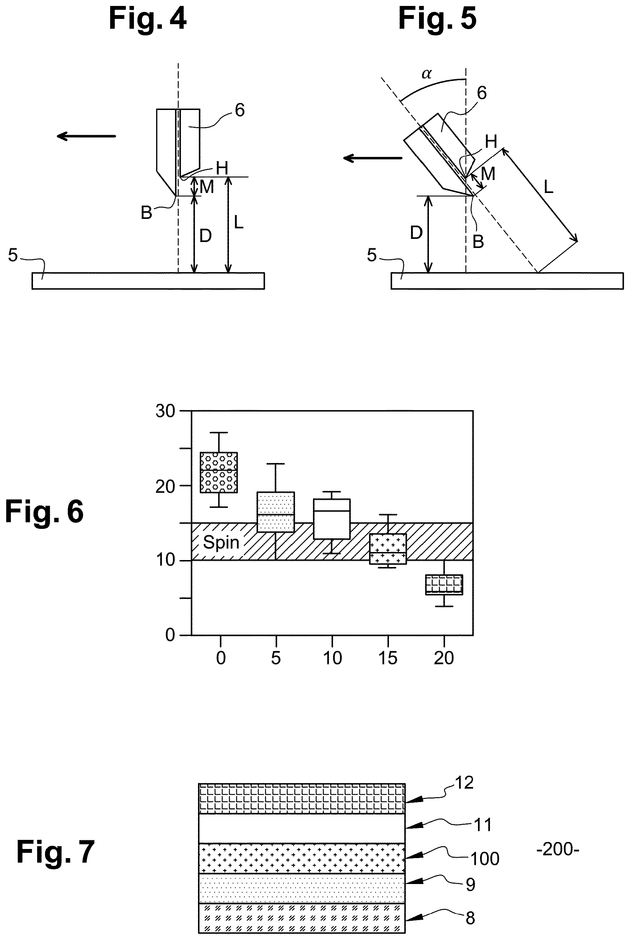

Les étapes du procédé sont illustrées sur les figures 1 à 3. La figure 1 illustre l'étape a) du procédé consistant à fournir un substrat 1 comportant une face de dépôt 2 sur une plateforme chauffante 3 dans une enceinte à atmosphère contrôlée (température d'environ 27°C et un taux d'humidité relative d'environ 20%). Dans le cadre de la préparation de dispositifs photovoltaïques, le substrat 1 utilisé est une structure (5 cm x 5 cm) constituée d'un support en verre (épaisseur 1.1 mm), recouvert d'une couche de ITO (couche d'oxyde d'indium et d'étain d'épaisseur environ 220 nm) elle-même recouverte d'une couche de SnO₂ (oxyde d'étain) préparée en vue de fabriquer une cellule solaire de type NIP (illustrée en figure 7). Typiquement, la couche de SnO₂ a été déposée au préalable par spin coating ou slot-die coating puis séchée à 80°C pendant une minute. Elle présente une épaisseur d'environ 50 nm et sa rugosité est d'environ 5 nm.

Un substrat 1 constitué d'une structure pour cellule solaire de type PIN peut également être utilisé, tout comme un substrat 1 permettant de fabriquer une structure de type tandem utilisant du silicium.

Un traitement thermique est appliqué via la plateforme chauffante 3 sur le substrat 1 au travers de la face opposée à la face de dépôt 2. Ce traitement thermique est contrôlé de sorte que la température de la face dépôt 2 du substrat 1 soit maintenue à environ 58°C (plateforme 3 chauffée à 60°C et épaisseur du substrat 1 d'environ 1,1 mm).

Une solution précurseur de la couche de pérovskite 100 est préparée en vue de son dépôt par « slot die coating » sur la face de dépôt 2. La solution est obtenue par ajout des précurseurs suivant PbI₂, (2,296g), PbBr₂ (0,375g), FAI (0,919g) et de Csl (0,234g) dans 5 ml d'un mélange de 1 ml de DMSO et de 4 ml de DMF. La concentration du Pb dans la solution est d'environ 1.2M et le rapport molaire de Cs sur le Pb est d'environ 15%.

Après environ 12 heures sous agitation à 40°C, la solution précurseur est prête au dépôt selon l'étape b) du procédé. La tête de dépôt 4 du dispositif de 'slot die coating' est disposée à environ 100 micromètres de la face de dépôt 2 et projette la solution précurseur avec un débit d'environ 100 microlitres/min de sorte à former un film humide 5 d'environ 3 micromètres d'épaisseur. La vitesse relative entre la face de dépôt 2 (immobile dans cet exemple de réalisation) et la tête de dépôt 4 est d'environ 28 mm/s.

Comme illustré à la figure 2, une fois que la tête de dépôt 4 a formé une surface de film humide 5 suffisamment importante, par exemple ici 5 cm dans une direction longitudinale d'avancement, une buse de projection 6 d'un dispositif à couteau à gaz applique un flux de d'azote vertical en direction la surface exposée du film humide 5. La buse de projection 6 illustrée à la figure 4 est disposée pour projeter le flux d'azote en formant un angle α de 90° avec la surface exposée du film humide 5 La longueur L de la trajectoire du flux du gaz entre la buse 6 et la surface exposée du film humide 5 comprend la distance verticale D entre le film humide 5 et le point bas B à la sortie de la buse de projection 6, mesurée à la verticale (ici 3 mm) et la distance M entre le point haut H et le point bas B à la sortie de la buse de projection 6, ici délimité par un méplat de 3 mm. La longueur L de la trajectoire du flux d'azote est ainsi de 6 mm.

Le flux d'azote présente par ailleurs une vitesse de 120 m/s et permet de cristalliser le film humide 5 pour former une couche de pérovskite 100 cristalline Cs_{0.15}FA_{0.85}Pb(I_{0.88}Br_{0.12})₃ d'une épaisseur d'environ 500 nm. Les dispositifs NIP décrits en figure 7 intégrant cette couche pérovskite ont des performances de 15.01 % pour le dispositif champion sur une surface active de 33 mm² (voir Tableau 1).

La buse de projection 6 se déplace avec une vitesse de 28 mm/s. Le temps de cycle du procédé dure moins de 2 minutes au total.

Selon une étape d) (non illustrée) du procédé, un recuit thermique est appliqué sur la couche de pérovskite 100 cristallisée pendant 5 min à 100°C. Ce traitement permet d'optimiser la structure cristalline et d'évacuer toute trace de solvant de la couche de pérovskite 100 observée par analyse DRX (acronyme de Diffraction par Rayons X).

### Deuxième exemple de réalisation du procédé de fabrication d'une couche de pérovskite 100 cristalline selon l'invention par blade coating :

Dans ce deuxième exemple, la solution précurseur présente les quantités de précurseurs suivants PbI₂, (2,296g), PbBr₂ (0,375g), FAI (0,816g) et de Csl (0,234g) dissous dans 9 ml d'un mélange composé de 8 ml de DMF et un 1 ml de DMSO. La concentration du Pb dans la solution est d'environ à 0,6 M et le rapport molaire de Cs sur le Pb est d'environ 15%. Après agitation de la solution précurseur à 40°C sur environ 12h, le dépôt est réalisé par un dispositif de 'blade coating' sur une face de dépôt 2 du substrat 1 présentant une température d'environ 43°C. La distance entre la lame d'étalement du dispositif 'blade coating' et la face de dépôt 2 du substrat 1 est d'environ 70 micromètres. La vitesse relative entre la face de dépôt 2 et la lame d'étalement est proche de celle du premier exemple (25 mm/s) et le volume d'encre utilisé est de 40 microlitres. Le flux d'azote est appliqué sur la surface exposée du film humide 5 avec une vitesse d'environ 137 m/s. La buse de projection 6 du flux d'azote est disposée de sorte que la longueur L de la trajectoire du flux gazeux est d'environ 3.6 mm. La buse 6 se déplace à une vitesse de 5 mm/s.

La buse de projection 6 est orientée de sorte que le flux d'azote est projeté en formant un angle α de 50° avec la surface exposée du film humide 5 (figure 5). Une couche de pérovskite 100 cristalline de formule brute Cs_{0.15}FA_{0.85}Pb(I_{0.88}Br_{0.12})₃ est obtenue avec une grande qualité sans nécessiter l'application d'un traitement thermique ultérieur. Selon une possibilité non illustrée, la lèvre haute délimitant le point haut H à la sortie de la buse est inversée avec la lèvre basse délimitant le point bas B, sans changement des paramètres du flux gazeux.

### Troisième exemple de réalisation du procédé de fabrication d'une couche de pérovskite 100 cristalline selon l'invention par blade coating :

Dans ce troisième exemple, la solution précurseur présente les quantités de précurseurs suivants PbI₂, (3,707g), PbBr₂ (1,453g), FAI (1,631g) et de Csl (0,468g) dissous dans 12 ml d'un mélange composé de 10,8 ml de DMF et un 1,2 ml de DMSO. La concentration du Pb dans la solution est d'environ à 1 M et le rapport molaire de Cs sur le Pb est d'environ 15%. Après agitation de la solution précurseur à 40°C environ 12h, le dépôt est réalisé par un dispositif de 'blade coating' sur une face de dépôt 2 du substrat 1 présentant une température d'environ 40°C. La distance entre la lame d'étalement du dispositif 'blade coating' et la face de dépôt 2 du substrat 1 est d'environ 70 micromètres. La vitesse relative entre la face de dépôt 2 et la lame d'étalement est proche de celle du premier exemple (20 mm/s) et le volume d'encre utilisé est de 20 microlitres. Le flux d'azote est appliqué sur la surface exposée du film humide 5 avec une vitesse d'environ 137 m/s. La buse de projection 6 du flux d'azote est disposée de sorte que la longueur L de la trajectoire du flux gazeux est d'environ 3.6 mm. La buse 6 se déplace à une vitesse de 5 mm/s.

La buse de projection 6 est orientée de sorte que le flux d'azote est projeté en formant un angle α de 50° avec la surface exposée du film humide 5. Un traitement thermique d'une durée de 5 minutes à une température de 100°C sous atmosphère inerte est réalisée après le passage de la buse de projection. Une couche de pérovskite 100 cristalline est obtenue avec une grande qualité.

### Analyses et mesures réalisées à partir des couches de pérovskites formées selon le procédé de fabrication de l'invention

Différentes couches de pérovskite 100 ont été fabriquées par un dispositif de slot die coating et de blade coating pour différents rapports molaires Cs/Pb allant de 0 à 20% (les autres éléments restant inchangés) ainsi qu'une couche formée par spin coating comprenant un rapport molaire Cs/Pb de 5% pour comparaison.

Les analyses des couches formées montrent que la présence césium est nécessaire pour former la bonne phase de pérovskite (la phase dite noire) par le procédé de l'invention, comme pour un dépôt realisé par spin-coating. Toutefois, il a été observé qu'un rapport Cs / Pb plus grand est nécessaire pour atteindre des propriétés de film optimales en termes d'absorbance et de rugosité, pour les couches obtenues selon le procédé de l'invention. En effet, des propriétés comparables avec celles obtenues par la technique de spin coating ont été atteintes avec un rapport Cs / Pb de 5% et les meilleures propriétés de la couche de pérovskite 100 ont été obtenues pour un rapport Cs / Pb de 15%. La figure 6 illustre les différentes rugosités observées selon la technique de dépôt et le rapport molaire Cs/Pb (rugosité en ordonnée et rapport molaire en abscisse). La bande horizontale illustre la rugosité obtenue par spin coating avec un rapport Cs / Pb de 5%, il est nécessaire d'utiliser un rapport molaire Cs / Pb de 10% et plus dans le cas d'un dépôt par slot die coating pour obtenir une rugosité similaire. Les analyses par DRX (non illustré) confirment également ces résultats. L'intensité des pics est similaire avec un rapport molaire Cs / Pb de 15% par slot die coating à celle obtenue avec un dépôt par spin coating, comprenant un rapport molaire Cs / Pb de 5%.

Ces résultats montrent que des couches de pérovskites avec une teneur plus élevée en Cs que celle obtenues par spin coating sont appropriées pour une intégration dans des dispositifs PV lorsqu'ils sont traités par le procédé de la présente invention.

Les mesures de rugosité ont été réalisées à l'aide d'un profilomètre de la marque Bruker.

### Mise en œuvre des couches de pérovskite préparées selon l'invention dans des cellules solaires :

### Configuration dite N-I-P :

Les couches de pérovskite 100 préparées telles que précédemment décrites sont déposées sur des substrats 1 comprenant un support 7 en verre, une couche d'ITO 8 (électrode transparente) / une couche de SnO₂ 9 (couche d'extraction d'électrons ou 'electron extracting layer') de forme carrée de 5 cm x 5 cm. Afin de terminer la fabrication du dispositif, une couche d'extraction de trous 11 communément appelée 'holes extracting layer' de PTAA dopé est déposée par dépôt à la tournette sur la couche de pérovskite 100, puis une électrode supérieure en or 12 est évaporée en surface (se référer à l'empilement de la figure 7).

### Configuration dite P-I-N :

Dans cette autre configuration, les couches de pérovskite préparées telles que précédemment décrites ci-dessus sont déposées sur des substrats comprenant un support en verre, une couche d'ITO (électrode transparente) / une monocouche auto-assemblée de 2-Pacz (ou [2-(9H-Carbazol-9-yl)ethyl] phosphonic Acid fourni par la société TCI America - numéro CAS : 20999-38-6 ) formant la couche d'extraction de trous ou 'hole extracting layer', de forme carrée de 5 cm x 5 cm. Afin de terminer la fabrication du dispositif, une couche d'extraction d'électrons communément appelée 'électrons extracting layer' de PCBM (ou [6,6]-phényl-C₆₁-butanoate de méthyle fourni par Sigma Aldrich- numéro CAS 160848-22-6) est déposée par dépôt à la tournette sur la couche de pérovskite, puis une couche de BCP (ou Bathocuproine, dérivé de la 1,10- phénantroline, fourni par Sigma Aldrich - numéro CAS 4733-39-5) et une électrode supérieure en argent sont évaporées en surface.

Les performances photovoltaïques des cellules solaires 200 ont été mesurées à 25 °C dans des conditions standards d'éclairement (1000 W.m⁻², AM 1,5 G) avec un simulateur solaire de la marque Newport. Les courbes courant-tension ont été enregistrées à l'aide d'un Keithley. Les résultats sont consignés dans le tableau 1 ci-dessous.

La première ligne du tableau 1 rapporte les résultats obtenus pour une couche de pérovskite déposée par spin coating qui sert de référence.

Le premier exemple de réalisation de couche de pérovskite 100 (slot die coating tel que précédemment décrit) a été répété pour fabriquer six dispositifs 200 préparés sous la forme de cellules avec une surface active de 33 mm². Les résultats sont consignés à la deuxième ligne du tableau 1. Sur la troisième ligne du tableau 1 sont indiqués les résultats obtenus à partir de cellules 200 préparées selon l'invention avec un rapport Cs / Pb similaire à celui du spin coating (5%) à titre de comparaison.

A la lecture du tableau, on peut constater que les performances des cellules solaires 200 sont augmentées pour la couche de pérovskite 100 obtenue par slot die coating avec le contenu Cs le plus élevé. Les meilleures performances sont similaires pour les cellules 200 obtenues par le procédé de dépôt par blade coating et slot die coating et donnent des valeurs autour de 15% de PCE. Ainsi, les couches de pérovskite 100 obtenues selon le procédé de la présente invention sont d'une grande qualité et peuvent être mise en œuvre dans des cellules solaires 200 de pérovskite très efficaces.

Les lignes quatre à six du Tableau 1 rapportent les résultats obtenus pour des cellules 200 fabriquées selon le deuxième mode de réalisation du procédé (blade coating) avec un rapport Cs / Pb de 15%. La quatrième et la cinquième ligne rapporte les résultats obtenus avec une concentration molaire de Pb dans la solution précurseur respectivement de 0,6 M et de 1M, cette dernière concentration conduisant à une meilleure performance PCE. La sixième ligne rapporte les résultats obtenus pour une configuration P-I-N avec une concentration molaire de Pb de 1M. Les cellules 200 de ces trois exemples ont été préparées sous forme de modules comprenant 8 bandes reliées en série avec une surface active totale de 10 cm².

**Tableau 1**

| **Conditions du dépot** | **V_{OC} (V)** | **J_{SC} (mA.cm⁻²)** | **FF (%)** | **PCE (%)** |
|---|---|---|---|---|
| **Dépôt par Spin coating⁽¹⁾⁽³⁾ (1,2 M en Pb - Cs/Pb 5%)** | 1,010 +- 0,040 1,049 | 22,42 +- 0,70 23,00 | 65 +- 3 68,0 | 14,75 +- 0,8 15,5 |
| **Dépôt par Slot die coating⁽¹⁾⁽³⁾ (1,2M en Pb - Cs/Pb 15%)** | 0,932 +- 0,070 1,004 | 21,56 +- 1,5 23,10 | 65,7 +- 6 71,2 | **13,63 +- 1,5 15,01** |
| **Dépôt par Slot die coating⁽¹⁾⁽³⁾ (0,9 M en Pb - Cs/Pb 5%)** | 0,990 +- 0,010 0,997 | 20,47 +- 0,50 20,79 | 58,5 +- 4 62,3 | 11,79 +-1 12,79 |
| **Dépôt par blade coating⁽²⁾⁽³⁾ (0,6 M en Pb - Cs/Pb 15%)** | 8.17 | 2.52 | 63.3 | **13.0** |
| **Dépôt par blade coating⁽³⁾ (1M en Pb - Cs/Pb 15%)** | 9.28 | 2.54 | 69.4 | 16.8 |
| **Dépôt par blade coating (1M en Pb - Cs/Pb 15%) configuration P-I-N** | 8.37 | 2.45 | 64.1 | **13.7** |

| | | | | |
|---|---|---|---|---|
| ⁽¹⁾ Résultat sur 6 cellules de 33 mm². ⁽²⁾ Meilleur résultat obtenu pour des cellules préparées sous forme de modules comprenant 8 bandes de reliées en série. ⁽³⁾ Configuration N-I-P. | | | | |

En conclusion, l'invention permet d'optimiser le procédé de fabrication d'une couche de pérovksite 100 à multi-cations. Elle permet de former une couche cristalline 100 de qualité, dans des conditions adaptées à une solution industrielle et sans nécessiter de recuit thermique de cristallisation. L'intégration de ces couches dans des dispositifs de type cellule solaire 200 est possible et conduit à de très bons résultats.

## Revendications

1. Procédé de fabrication d'une couche de pérovskite (100) à multi-cations, en vue de former une couche photo-active, le procédé comprenant les étapes de :
- a) fourniture d'un substrat (1) présentant une face de dépôt (2),
- b) dépôt d'une solution précurseur comprenant au moins un solvant et des précurseurs de la pérovskite de sorte à former un film humide (5) sur la face de dépôt (2), les précurseurs comprenant au moins du CsX, FAY, PbZ₂, avec FA = HC(NH₂)₂; X, Y et Z = I, Br, et les quantités étant déterminées de sorte que le rapport molaire du césium par rapport au plomb est compris entre environ 4% et 22 %, et de préférence entre 13% et 20%, et que la couche de pérovskite (100) présente une formule brute du type CsₓFA₍₁₋ₓ₎Pb(I_{y}Br_{(1-y)})₃ avec x compris entre 0.04 et 0.22 et y compris entre 0 et 1, et
- c) balayage d'une surface exposée du film humide (5) par un flux d'air sec ou de gaz inerte présentant une vitesse de sorte à cristalliser la couche de pérovskite (100) à multi-cations,
le procédé comprenant en outre l'application d'un traitement thermique sur le substrat (1) de sorte que la face de dépôt (2) présente une température allant d'environ 25°C à 80°C au moins pendant l'étape b),
le procédé est **caractérisé en ce que** la vitesse du flux d'air sec ou de gaz inerte est comprise entre 120 m/s et 250 m/s.

2. Procédé de fabrication selon la revendication précédente dans lequel l'application d'un traitement thermique sur le substrat (1) est réalisée de sorte que la face de dépôt (2) présente une température allant entre environ 30°C et 70°C, et de préférence entre environ 40°C et 60°C.

3. Procédé de fabrication selon l'une des revendications 1 à 2, dans lequel les précurseurs de la couche de pérovskite (100) sont choisis parmi une combinaison de CsX, FAY et PbZ₂, avec X, Y et Z = I , Br.

4. Procédé de fabrication selon l'une des revendications précédentes, dans lequel l'au moins un solvant est choisi parmi le DMF et /ou le DMSO.

5. Procédé de fabrication selon l'une des revendications précédentes, dans lequel la concentration molaire du plomb dans la solution précurseur est comprise entre 0.5 M et 1.5 M.

6. Procédé de fabrication selon l'une des revendications précédentes, dans lequel le seul budget thermique appliqué pendant le procédé de fabrication est fourni par le traitement thermique appliqué au substrat (1) de sorte que la face de dépôt (2) présente une température allant d'environ 25°C à 80°C pendant les étapes b) et c).

7. Procédé de fabrication selon l'une des revendications 1 à 5, dans lequel l'étape c) d'application du flux de gaz inerte ou d'air sec est suivie d'une étape d) d'application d'un recuit thermique réalisé à une température comprise entre 70°C et 100°C pendant une durée inférieure ou égale à 5 min.

8. Procédé de fabrication selon l'une des revendications 1 à 7, dans lequel, l'étape c) de balayage par un flux de gaz inerte ou d'air sec est réalisée par un déplacement relatif du substrat (1) comprenant le film humide (5) et d'une buse de projection (6), telle qu'une buse de projection d'un couteau à gaz, la buse de projection étant disposée de sorte que la longueur (L) de la trajectoire du flux du gaz inerte ou de l'air sec entre la sortie de la buse de projection (6) et la surface exposée du film humide (5) est comprise entre environ 3.1 millimètres et 6 millimètres, et de préférence entre environ 3.1 millimètres et 4 millimètres.

9. Procédé de fabrication selon la revendication précédente dans lequel la vitesse de déplacement relatif entre le film humide (5) et la buse de projection (6) lors de l'étape c) est comprise entre 1 et 50 mm/s et de préférence entre 5 et 30 mm/s.

10. Procédé de fabrication selon la revendication 8 ou 9, dans lequel l'angle α formé entre le flux de gaz inerte ou d'air sec et le film humide est compris entre 90° et 45°.

11. Procédé de fabrication selon l'une des revendications précédentes, dans lequel l'étape b) de dépôt de la solution précurseur est effectuée par enduction via une filière plate ou via un couchage à lame, de sorte à obtenir un film humide (5) d'une épaisseur constante et d'une concentration homogène.

12. Procédé de fabrication selon l'une des revendications précédentes dans lequel l'étape b) de dépôt de la solution précurseur est réalisée de sorte à obtenir une épaisseur de film humide (5) constante, comprise entre 2 et 16 micromètres préférentiellement entre 2,5 et 8 micromètres et de préférence encore entre 3 et 5 micromètres.

## Patentansprüche

1. Verfahren zur Herstellung einer mehrkationigen Perowskitschicht (100) zum Bilden einer fotoaktiven Schicht, wobei das Verfahren die Schritte umfasst zum:
- a) Bereitstellen eines Substrats (1), das eine Abscheidefläche (2) aufweist,
- b) Abscheiden einer Vorläuferlösung, die mindestens ein Lösungsmittel und Perowskit-Vorläufer umfasst, um einen Nassfilm (5) auf der Abscheidefläche (2) zu bilden, wobei die Vorläufer mindestens CsX, FAY, PbZ₂ umfassen, mit FA = HC(NH₂)_{2;} X, Y und Z = I, Br, und die Mengen bestimmt sind, sodass das Molverhältnis von Cäsium in Bezug zu Blei zwischen etwa 4% und 22 % und vorzugsweise zwischen 13% und 20% liegt, und die Perowskitschicht (100) eine Rohformel vom Typ CSₓFA₍₁₋ₓ₎Pb(I_{y}Br_{(1-y)})₃ mit x aufweist, das zwischen 0,04 und 0,22, liegt und zwischen 0 und 1 liegt, und
- c) Überströmen einer exponierten Oberfläche des Nassfilms (5) mit einem Trockenluft- oder Inertgasstrom, der eine Geschwindigkeit aufweist, um die mehrkationige Perowskitschicht (100) zu kristallisieren,
wobei das Verfahren, weiter das Anwenden einer Wärmebehandlung auf dem Substrat (1) umfasst, sodass die Abscheidefläche (2) mindestens während des Schritts b) eine Temperatur aufweist, die von etwa 25°C bis 80°C reicht,
das Verfahren **dadurch gekennzeichnet ist, dass** die Geschwindigkeit des Trockenluft- oder Inertgasstroms zwischen 120 m/s und 250 m/s umfasst ist.

2. Verfahren zur Herstellung nach dem vorstehenden Anspruch, wobei das Anwenden einer Wärmebehandlung auf dem Substrat (1) durchgeführt wird, sodass die Abscheidefläche (2) eine Temperatur aufweist, die zwischen etwa 30°C und 70 °C , und vorzugsweise zwischen etwa 40°C und 60°C reicht.

3. Verfahren zur Herstellung nach einem der Ansprüche 1 bis 2, wobei die Vorläufer der Perowskitschicht (100) aus einer Kombination von CsX, FAY und PbZ₂, mit X, Y und Z = I, Br ausgewählt sind.

4. Verfahren zur Herstellung nach einem der vorstehenden Ansprüche, wobei das mindestens eine Lösungsmittel aus DMF und/oder DMSO ausgewählt ist.

5. Verfahren zur Herstellung nach einem der vorstehenden Ansprüche, wobei die Molkonzentration des Bleis in der Vorläuferlösung zwischen 0,5 M und 1,5 M umfasst ist.

6. Verfahren zur Herstellung nach einem der vorstehenden Ansprüche, wobei das einzige während des Verfahrens zur Herstellung angewandte Wärmebudget durch die auf dem Substrat (1) angewendete Wärmebehandlung bereitgestellt wird, sodass die Abscheidefläche (2) während der Schritte b) und c) eine Temperatur von etwa 25°C bis 80°C aufweist.

7. Verfahren zur Herstellung nach einem der Ansprüche 1 bis 5, wobei dem Schritt c) zum Anwenden des Inertgas- oder Trockenluftstroms ein Schritt d) zum Anwendung eines Temperns folgt, das bei einer Temperatur durchgeführt wird, die zwischen 70°C und 100°C eine Dauer von weniger als oder gleich 5 min lang umfasst ist.

8. Verfahren zur Herstellung nach einem der Ansprüche 1 bis 7, wobei der Schritt c) zum Überströmen mit einem Inertgas- oder Trockenluftstrom durch eine relative Verschiebung des Substrats (1), das den Nassfilm (5) umfasst, und einer Spritzdüse (6), wie beispielsweise einer Spritzdüse eines Gasmessers, durchgeführt wird, wobei die Spritzdüse angeordnet ist, sodass die Länge (L) der Bahn des Inertgas- oder Trockenluftstroms zwischen dem Ausgang der Spritzdüse (6) und der exponierten Oberfläche des Nassfilms (5) zwischen etwa 3,1 Millimetern und 6 Millimeter, und vorzugsweise zwischen etwa 3,1 Millimetern und 4 Millimeter umfasst ist.

9. Verfahren zur Herstellung nach dem vorstehenden Anspruch, wobei die relative Verschiebegeschwindigkeit zwischen dem Nassfilm (5) und der Spritzdüse (6) beim Schritt c) zwischen 1 und 50 mm/s und vorzugsweise zwischen 5 und 30 mm/s umfasst ist.

10. Verfahren zur Herstellung nach Anspruch 8 oder 9, wobei der zwischen dem Inertgas- oder Trockenluftstrom und dem Nassfilm gebildete Winkel α zwischen 90° und 45° umfasst ist.

11. Verfahren zur Herstellung nach einem der vorstehenden Ansprüche, wobei der Schritt b) zum Abscheiden der Vorläuferlösung durch Beschichten über eine Breitschlitzdüse oder über eine Klingenbeschichtung erfolgt, um einen Nassfilm (5) mit einer konstanten Dicke und einer homogenen Konzentration zu erhalten.

12. Verfahren zur Herstellung nach einem der vorstehenden Ansprüche, wobei der Schritt b) zum Abscheiden der Vorläuferlösung ausgeführt wird, um eine konstante Nassfilmdicke (5), die zwischen 2 und 16 Mikrometern, vorzugsweise zwischen 2,5 und 8 Mikrometern und noch bevorzugter zwischen 3 und 5 Mikrometern umfasst ist, zu erhalten.

## Claims

1. A method for manufacturing a multi-cation perovskite layer (100), for forming a photo-active layer, the method comprising the steps of:
- a) providing a substrate (1) having a deposition face (2),
- b) depositing a precursor solution comprising at least one solvent and perovskite precursors so as to form a wet film (5) on the deposition face (2), the precursors comprising at least CsX, FAY, PbZ₂, with FA = HC(NH₂)₂; X, Y and Z = I, Br, and the amounts being determined such that the molar ratio of cesium to lead is comprised between about 4% and 22%, and preferably between 13% and 20%, and such that the perovskite layer (100) has a formula of the type CsₓFA₍₁₋ₓ₎Pb(I_{y}Br_{(1-y)})₃ with x comprised between 0.04 and 0.22 and y comprised between 0 and 1, and
- c) sweeping an exposed surface of the wet film (5) by a flow of dry air or inert gas having a velocity so as to crystallize the multi-cation perovskite layer (100),
the method further comprising applying a heat treatment to the substrate (1) such that the deposition face (2) has a temperature ranging from about 25°C to 80°C at least during step b),
the method is **characterized in that** the velocity of the flow of dry air or inert gas is comprised between 120 m/s and 250 m/s.

2. The manufacturing method according to the preceding claim, wherein the application of a heat treatment to the substrate (1) is carried out such that the deposition face (2) has a temperature ranging between about 30°C and 70°C, and preferably between about 40°C and 60°C.

3. The manufacturing method according to any of claims 1 to 2, wherein the precursors of the perovskite layer (100) are selected from a combination of CsX, FAY and PbZ₂, with X, Y and Z = I, Br.

4. The manufacturing method according to any of the preceding claims, wherein the at least one solvent is selected from DMF and/or DMSO.

5. The manufacturing method according to any of the preceding claims, wherein the molar concentration of lead in the precursor solution is comprised between 0.5 M and 1.5 M.

6. The manufacturing method according to any of the preceding claims, wherein the sole thermal budget applied during the manufacturing method is provided by the heat treatment applied to the substrate (1) such that the deposition face (2) has a temperature ranging from about 25°C to 80°C during steps b) and c).

7. The manufacturing method according to any of claims 1 to 5, wherein step c) of applying the flow of inert gas or dry air is followed by a step d) of applying thermal annealing carried out at a temperature comprised between 70°C and 100°C for a duration less than or equal to 5 min.

8. The manufacturing method according to any of claims 1 to 7, wherein step c) of sweeping by a flow of inert gas or dry air is carried out by a relative movement of the substrate (1) comprising the wet film (5) and a projection nozzle (6), such as a projection nozzle of a gas knife, the projection nozzle being arranged such that the length (L) of the trajectory of the flow of inert gas or dry air between the outlet of the projection nozzle (6) and the exposed surface of the wet film (5) is comprised between about 3.1 millimeters and 6 millimeters, and preferably between about 3.1 millimeters and 4 millimeters.

9. The manufacturing method according to the preceding claim, wherein the relative movement speed between the wet film (5) and the projection nozzle (6) during step c) is comprised between 1 and 50 mm/s and preferably between 5 and 30 mm/s.

10. The manufacturing method according to claim 8 or 9, wherein the angle α formed between the flow of inert gas or dry air and the wet film is comprised between 90° and 45°.

11. The manufacturing method according to any of the preceding claims, wherein step b) of depositing the precursor solution is carried out by coating via a flat die or via blade coating, so as to obtain a wet film (5) of constant thickness and homogeneous concentration.

12. The manufacturing method according to any of the preceding claims, wherein step b) of depositing the precursor solution is carried out so as to obtain a constant wet film (5) thickness, comprised between 2 and 16 micrometers, preferably between 2.5 and 8 micrometers, and more preferably between 3 and 5 micrometers.
